# EUROPEAN PATENT APPLICATION

(11) **EP 1 477 851 A1**
(43) Date of publication of application: **17.11.2004**
(21) Application number: 03252966.1
(22) Date of filing: 13.05.2003
(51) Int. Cl.: G03F 7/20

(54) **Device manufacturing method and lithographic apparatus**

(71) Applicant: ASML Netherlands B.V., 5504 DR Veldhoven (NL)
(72) Inventor: The designation of the inventor has not yet been filed
(74) Representative: Leeming, John Gerard

(57) **Abstract**

A system in which deformation of a substrate wafer is monitored during processing of the wafer is disclosed. The distortion in the substrate wafer is measured after each exposure and processing step by comparing the position of a plurality of reference marks 20 to values in a database.

## Description

The present invention relates to a device manufacturing method comprising the steps of:
- applying a plurality of reference marks to a substrate;
- exposing a pattern onto a photosensitive layer of said substrate to imprint a latent pattern;
- developing said latent pattern in said photosensitive layer to reveal said pattern;
- processing said substrate; and
- measuring the relative positions of said reference marks on said substrate.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference. In the case of a programmable mirror array, the said support structure may be embodied as a frame or table, for example, which may be fixed or movable as required.
- A programmable LCD array. An example of such a construction is given in United States Patent US 5,229,872, which is incorporated herein by reference. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (*e.g.* comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus ―commonly referred to as a step-and-scan apparatus ― each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792, incorporated herein by reference.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4, incorporated herein by reference.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791, incorporated herein by reference.

Manufacturing a typical device by a lithographic process requires a plurality of cycles each of several steps. These include the steps of: coating the substrate with a photosensitive material, projecting an image on the photosensitive material, developing the photosensitive material and processing the substrate, which can include covering the substrate in a new layer of material. One of the problems encountered with the lithographic process is that successive layers are not accurately imaged on top of each other so that there is a so-called overlay error. In order to avoid proceeding onto the subsequent steps when an overlay error already exists which would be detrimental to the component's performance; after each cycle the overlay error is measured. If the overlay error is too large then the most recent layer can be removed and that cycle repeated before proceeding onto the next cycle.

In order to minimise the overlay errors, substrates are provided with a plurality of reference marks so that the exact position of the substrate on a substrate table in a projection apparatus may be measured prior to the exposure step. In this way it is possible to maximise the accuracy of the exposure step because the relative positions of the substrate, the previously applied patterned layer and the mask in the lithographic apparatus are known.

Another problem with multi-cycle lithographic processes is the deformation of the substrate which can occur with the application of particular layers and/or particular patterns. Deformation includes, for example, topographic 3 dimensional deformation, deformation of the reference marks (shape or depth) or variation of layer properties or thicknesses deposited on the wafer. CMP is notorious for causing deformation of the substrate. With the use of substrate wafers with a diameter of 300mm or more, it is expected that wafer deformation will become an even more important factor. In order to minimise deformation, the processes need to be kept as uniform as possible over the whole area of the substrate. Deformation of the substrate wafer can lead to errors in the imaging of the wafer resulting in the need to repeat a particular step. Also, during the development of a process for a particular component manufactured by lithography the process is optimised to minimise, or at least keep within limits, the amount of substrate deformation. The reduction of overlay errors or errors as a result of substrate deformation or at least early detection of such errors leads to improved yield.

It is an object of the present invention to provide a device manufacturing method which improves yield.

This and other objects are achieved according to the invention in a method as specified in the opening paragraph, characterized by a step of comparing the results of said measuring step with information stored in a database.

With this method substrate deformation during manufacture can be monitored without a reduction in the through put because the step of measuring the relative positions of the reference marks takes less time than the exposure step and in some cases needs to be carried out in any case in order to gauge the positioning of the substrate relative to the protocol which is used in the exposing step.

If the result of the step of comparing is greater than a predetermined maximum, an operator may be alerted. This will improve yield for the customer as substrates which have deformed beyond a certain amount will be rejected before further exposing, developing and processing steps are carried out. Furthermore, during development of a multi-step process for the manufacture of a device using lithography, those steps which cause unacceptable substrate deformation can be identified at an early stage. With the invention, it is also possible to alert a user of the apparatus if the apparatus drifts such that sub-standard substrates are being manufactured.

The information may comprise any kind of data, for example raw position data, raw sensor data indicative of the substrate markers, calculations from the data, such as magnification, translation, rotation or differences of individual measurements with respect to a reference grid described by parameters, each relating to the substrate in general and/or the particular layer of concern.

If the information stored in the database is results of previous measuring steps, it is possible to accept or reject a substrate dependent on the deviation from the average measurement results or to highlight a change in processing conditions or a problem with the apparatus or processing conditions. Preferably in such a case the information is results of previous measuring steps on substrates of the same batch of substrates so that it is known that those substrates have all undergone the same processing. Of course, other comparisons may be made. For example, the information in the database used for the comparison may be values from the same layer in a different batch of wafers. A batch is a set of wafers subjected to the same steps.

Preferably, the method comprises the step of automatically storing the result of the said measuring and/or comparing steps in said database so that a history of results is saved. This may be useful as a diagnosis tool for engineers investigating a particular process with a view to optimising yield.

It is also possible to control the exposing step dependant on the results of the comparing step of the preceding cycle. Thus, the exposing step can be controlled to take account of the deformation of the substrate which has been measured, thereby to ensure that the exposing step exposes the substrate in such a way to account for the deformation present in the substrate.

According to a further aspect of the invention there is provided an apparatus comprising;
- a substrate table for holding a substrate;
- a measuring system for measuring relative positions of a plurality of reference marks on the substrate;
characterised in further comprising a database and a processor for comparing results of measurement by said measuring system with information in said database.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g.* with a wavelength of 365, 248, 193, 157 or 126 nm) and EUV (extreme ultraviolet radiation, *e.g.* having a wavelength in the range 5-20 nm), as well as particle beams, such as ion beams or electron beams.

Embodiments of the invention will now be described, by way of example only, with reference to the accompanying schematic drawings in which:
Figure 1 depicts a lithographic projection apparatus according to an embodiment of the invention;
Figure 2 depicts a substrate wafer with a typical pattern of reference marks; and
Figure 3 is a schematic illustration showing the various steps of the method according to an embodiment of the invention.

In the Figures, corresponding reference symbols indicate corresponding parts.

### Embodiment 1

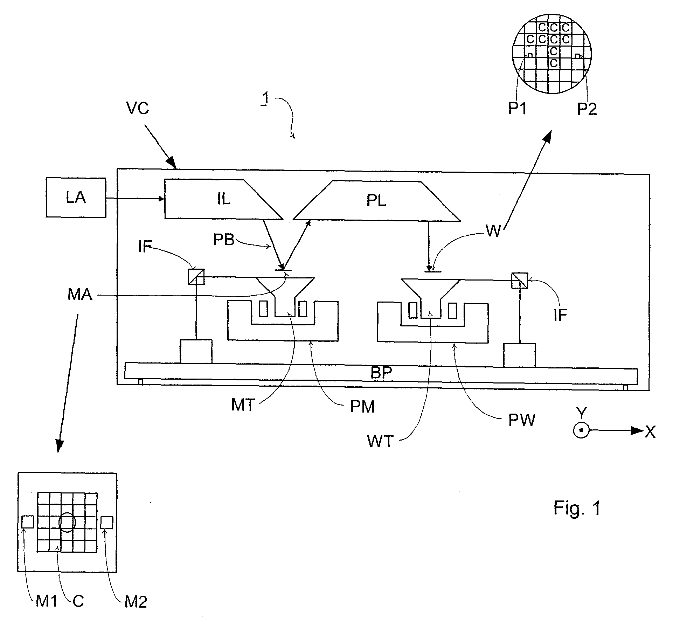

Figure 1 schematically depicts a lithographic projection apparatus according to a particular embodiment of the invention. The apparatus comprises:
· a radiation system Ex, IL, for supplying a projection beam PB of radiation (e.g. EUV radiation), which in this particular case also comprises a radiation source LA;
· a first object table (mask table) MT provided with a mask holder for holding a mask MA (*e.g.* a reticle), and connected to first positioning means for accurately positioning the mask with respect to item PL;
· a second object table (substrate table) WT provided with a substrate holder for holding a substrate W (e.g. a resist-coated silicon wafer), and connected to second positioning means for accurately positioning the substrate with respect to item PL;
· a projection system ("lens") PL (e.g. a mirror group) for imaging an irradiated portion of the mask MA onto a target portion C (e.g. comprising one or more dies) of the substrate W.

As here depicted, the apparatus is of a reflective type (e.g. has a reflective mask). However, in general, it may also be of a transmissive type, for example (e.g. with a transmissive mask). Alternatively, the apparatus may employ another kind of patterning means, such as a programmable mirror array of a type as referred to above.

The source LA (e.g. a laser-produced or discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having been selectively reflected by the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", e.g. the y direction) with a speed ν, so that the projection beam PB is caused to scan over a mask image; concurrently, the substrate table WT is simultaneously moved in the same or opposite direction at a speed *V* = *M*ν, in which *M* is the magnification of the lens PL (typically, *M* = ¼ or 1/5). In this manner, a relatively large target portion C can be exposed, without having to compromise on resolution.

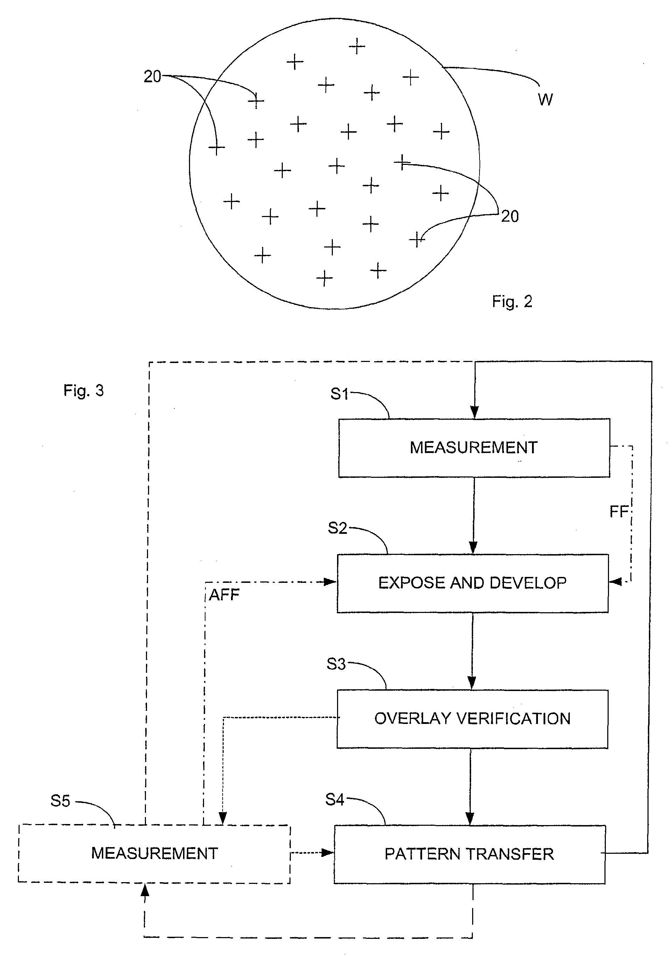

Figure 2 illustrates, in plan, a substrate W with a plurality of reference marks 20 which have been applied on the upper surface. In a dual stage lithographic projection apparatus the number of a reference marks 20 might be in the region of 25 per substrate W. There is plenty of time in the measurement step when using such apparatus for the precise measurement of the relative positions of each of the reference marks 20 on the substrate W.

Figure 3 illustrates the steps of the method. The first step of the method is a measurement step S1, in which the relative positions of each of the reference marks 20 on the substrate W are measured. This step can be performed in the lithographic projection apparatus where the position of the reference marks 20 are measured in any case for substrate W to substrate table WT alignment and levelling measurement, or it can be performed in a separate machine. The machine used in the measurement step S1 could be the same machine that is used for overlay verification which measures the alignment between two consecutive layers on the substrate W. This overlay verification step S3 will be described later.

During the measurement step S1 a measuring system measures the relative positions of the plurality of reference marks 20 on the substrate W under the control of a controller. A processor is used to compare the results of the measurement S1 with information/values in a database.

Several variations of the method are possible depending on the results of the comparison between the measured results with the information stored in the database. For example, an operator alerter may be activated if the comparison reveals that the substrate W is deformed beyond predetermined limits. Or alternatively the result of the comparison may be used by the controller to control the subsequent exposure of the substrate W. In either case, the result of the measurement step and the result of the comparing step may be automatically saved in the database to help build up a history of how the substrate deformation changes during its processing and added to the information. This is useful both as a history for that particular substrate as well as for use in comparing how different substrates have deformed over time.

Following the measurement step S1 the wafer is exposed in a lithographic projection apparatus and is subsequently developed (step S2 in Figure 3). Usually the reference marks 20 are uncovered at the end of the exposure and development step S2 such that further measurement may be performed using those reference marks 20 including overlay verification S3 in which the overlay accuracy is assessed. The next step, S4, is a pattern transfer step which can involve the deposition of a layer on, or doping of, by, for example, ion radiation, or etching of areas of the substrate not covered by photosensitive material (i.e. removed during development). Of course, before the next exposure in the lithographic projection apparatus the position and orientation of the substrate W is measured using the reference marks 20 relative to the support structure which supports the patterning means which itself serves to pattern a projection beam generated by a radiation system to a desired pattern. The projection beam is of course projected by a projection system onto a target portion of the substrate W.

In one embodiment a feed forward loop FF is used to control the exposure step of the exposure and develop step S2 to take into account the measured deformation and the result of the comparison in step S1.

Following the exposure and development step S2, an alignment measurement step S3 is performed in which the alignment of two subsequent layers deposited on the substrate W during consecutive cycles is measured. This process ensures that, should the alignment of the latest layer to its preceding layer be unsatisfactory, that latest layer can be removed and a new layer deposited so that no unnecessary effort is expended in applying further subsequent layers to the substrate W even when the detected misalignment between layers would render such a substrate useless.

Figure 3 shows an alternative or additional measurement step S5 in which the positions of the reference marks 20 are measured relative to each other and the results are compared to information in a database. It is convenient in certain types of apparatus to perform the alignment measurement step S3 and the measurement step S5 at the same time so as to free up the lithographic projection apparatus for exposing substrates which have already been measured (shown in dotted lines). Alternatively, the measurement step S5 may be performed after step S4 but independently of step S5. A feed forward control of the exposure step S2 is also possible (labelled AFF in Figure 3). It may then only be necessary to measure a few of the reference marks 20 in step S1 for aligning the position of the substrate W relative to the mask in the projection apparatus.

The measurement, exposure, development, alignment measurement and pattern transfer steps S1, S2, S3, S4 form a cycle which is performed a plurality of times as required according to the desired structure on the substrate W. The results of each measurement step S1, S5 may be automatically stored in the database by an automatic storer. In this way a history of deformation of the substrate W may be built up during its processing. This allows process engineers to identify which of the plurality of exposure, development and process steps S2, S4 results in unallowable amounts of deformation of the substrate W.

The first measurement step before the substrate W has been exposed may be performed without a comparison to a database. In this circumstance, no deformation of the substrate W would have occurred due to exposure or process because no exposure or process has yet occurred.

In some cases it may be advantageous in the comparing step to only compare values stored in the database which come from substrates W of the same batch of substrates W. It may be that substrates of different batches react in differing ways to given exposure, development and processing steps, such that only values from the same batch of substrates would form a valid comparison. The activation of the operator alerter could indicate to the operator either a drift in the settings of the lithographic projector apparatus or a substrate W which has been subjected to too large a deformation.

The values in the database may be values of previous measuring steps S1, S5 on the particular substrate W under consideration. If a comparison shows deformation between cycles, or overall, beyond a predetermined value, the operator alerter may be activated or the exposure step S2 controlled by the controller to account for the deformation.

The controller can control the exposure step S2 to account for position offset or non-orthogonal deformation (automatically or by alerting an operator to make a manual correction) or even higher order deformations (i.e. non-linear deformations).

Whilst specific embodiments of the invention have been described above, it will be appreciated that the invention may be practiced otherwise than as described. The description is not intended to limit the invention.

## Claims

1. A device manufacturing method comprising the steps of:
- applying a plurality of reference marks to a substrate;
- exposing a pattern onto a photosensitive layer of said substrate to imprint a latent pattern;
- developing said latent pattern in said photosensitive layer to reveal said pattern;
- processing said substrate; and
- measuring the relative positions of said reference marks on said substrate;
- **characterized by**
- a step of comparing the results of said measuring step with information stored in a database.

2. A method according to claim 1, wherein said information stored in said database are results of previous measuring steps.

3. A method according to claim 2, wherein said information are results of previous measuring steps on substrates of the same batch of substrates.

4. A method according to any one of claims 1 to 3, further comprising a first measuring step, after said applying step, in which the relative positions of said reference marks on said substrate are measured.

5. A method according to any one of the preceding claims, wherein a cycle comprising said exposing, processing, measuring and comparing steps is repeated a plurality of times.

6. A method according to claim 5, wherein said exposing step is controlled dependent upon the result of the comparing step of the preceding cycle.

7. A method according to claim 5 or 6, wherein said pattern includes a reference grid and said method comprises a further step of measuring alignment between the results of said processing step of consecutive cycles using said reference grid.

8. A method according to any one of the preceding claims, wherein if the result of the step of comparing is greater than a predetermined maximum, an operator is alerted.

9. A method according to any one of the preceding claims, further comprising the step of automatically storing the result of said measuring and/or comparing steps in said database.

10. An apparatus comprising;
- a substrate table for holding a substrate;
- a measuring system for measuring relative positions of a plurality of reference marks on the substrate;
**characterised in** further comprising a database and a processor for comparing results of said measuring system with values in said database.

11. A computer program comprising code means that, when executed on a computer system, is effective to control an apparatus to carry out the steps of the method of any of claims 1 to 9.
